# FASCICULE DE BREVET EUROPEEN

(11) **EP 2 804 754 B1**
(45) Date de publication et mention de la délivrance du brevet: **23.03.2022**
(21) Numéro de dépôt: 13700226.7
(22) Date de dépôt: 14.01.2013
(51) Int. Cl.: B32B 17/10, H01L 31/048, C03C 17/22, H01L 27/142, C03C 27/10

(54) **VITRAGE PHOTOVOLTAIQUE**
PHOTOVOLTAISCHE VERGLASUNG
PHOTOVOLTAIC GLAZING

(30) Priorité: 16.01.2012 BE 201200036
(43) Date de publication de la demande: 26.11.2014
(73) Titulaire: AGC Glass Europe, 1348 Louvain-La-Neuve (BE)
(72) Inventeur: AGUSTSSON, Otto, 1060 Saint-Gilles (BE); LECOMTE, Benoit, 4210 Marneffe (BE); CHORINE, Nicolas, 3053 Haasrode (BE); HUBERT, Renaud, 5300 Landenne (BE)
(74) Mandataire: AGC Glass Europe
(86) Numéro de dépôt international: PCT/EP2013/050549
(87) Numéro de publication internationale: WO 2013/107706

(56) Documents cités:
- EP-A2- 0 221 287
- EP-A2- 0 343 628
- WO-A1-2007/142515
- FR-A1- 2 413 232
- JP-A- 2005 158 801
- US-A1- 2003 005 954

## Description

L'invention est relative aux vitrages de véhicules comprenant dans un ensemble verrier feuilleté des générateurs photovoltaïques sous forme de couches supportées par un substrat verrier.

Le document EP0343628 concerne un substrat de verre pour une cellule solaire ayant une surface incurvée convenant à un panneau de verre de fenêtre pour une automobile, un procédé de production de celui-ci, et une cellule solaire.

Pour améliorer le bilan énergétique des véhicules, de nombreuses propositions concernent l'incorporation de cellules photovoltaïques sur les surfaces de la carrosserie qui se prêtent à cet usage. En particulier il a été proposé de disposer des cellules dans des vitrages entrant dans la composition de toits ou dans les lunettes arrière. Dans la suite par mesure de simplification il est question de toits mais les dispositions proposées peuvent aussi s'appliquer à d'autres vitrages.

Pour optimiser l'énergie produite la surface exposée comprenant les dispositifs photovoltaïques couvre une partie importante, ou même la totalité du toit. De telles dispositions trouvent des applications pour tous les véhicules automobiles et notamment les véhicules électriques.

La pratique la plus usuelle pour des systèmes photovoltaïques situés sur des véhicules consiste à les exposer en les protégeant vers l'extérieur par une feuille aussi transparente que possible aux rayons actiniques, traditionnellement en verre. Au-delà, les cellules traditionnelles étant opaques, elles sont ordinairement incluses dans un ensemble qui est opaque à la lumière. Il peut s'agir d'un revêtement qui protège et masque le dispositif à la vue depuis l'habitacle.

La recherche de solutions économiques, satisfaisantes pour ce qui concerne le rendement énergétique, conduit à remplacer les cellules traditionnelles par des dispositifs comprenant une ou plusieurs couches de matériau semi-conducteur photosensible disposé entre deux électrodes dont une au moins, du côté de la lumière incidente, est transparente à la lumière. Parmi les matériaux semiconducteurs, le silicium est disponible et relativement peu couteux. Il constitue donc un matériau particulièrement apte à répondre à cette attente. Les techniques qui permettent de l'appliquer sont aussi bien connues, et se prêtent bien au développement des systèmes comprenant un ensemble de couches sur un support qui doit aussi être transparent.

Par ailleurs le choix de toits comprenant de grandes surfaces de verre s'est développé récemment. Pour les constructeurs il s'agit d'bord de proposer un toit qui laisse passer une fraction de la lumière pour ouvrir davantage l'espace de l'habitacle vers l'extérieur. La proportion de transmission lumineuse n'est pas nécessairement très importante. L'impression « d'ouverture » existe même pour des transmissions aussi faibles que 5%, et devient très sensible si la transmission est de l'ordre de 10% ou plus.

Le choix de systèmes photovoltaïques intégrés dans des toits de véhicules doit prendre en compte la configuration de ces toits. En particulier, sauf exception, pour des raisons aérodynamiques et esthétiques, les toits ne sont généralement pas plats, mais au moins légèrement incurvés. Cette particularité est bien maîtrisée par les industriels verriers. La formation de vitrages, en particulier de vitrages feuilletés pour les toits de véhicules est de pratique usuelle.

Les couches photovoltaïques et celles qui leurs sont associées, notamment les couches conductrices, doivent pouvoir être disposées sur des supports qui ne sont pas plans mais au moins légèrement incurvés. Le dépôt de ces couches minces de façon bien uniforme passe par des techniques qui ne peuvent se faire que sur des substrats plats, qu'il s'agisse par exemple des techniques de pulvérisation cathodique sous vide, qu'il s'agisse de pyrolyse de précurseurs gazeux ou liquides ou de techniques analogues...Partant d'une formation sur un substrat plat celui-ci doit pouvoir être mis en forme pour se conformer au modèle choisi par le constructeur.

Une difficulté rencontrée dans la mise en forme des substrats de nature verrière est le fait que celle-ci implique des traitements thermiques à des températures qui ne sont pas inférieure à 600°C et le plus souvent se situent à 650-700°C, alors que les couches photovoltaïques notamment à base de silicium ne supportent pas ordinairement des températures supérieures à 200-300°C.

Pour résoudre cette difficulté, les inventeurs proposent de procéder de la façon faisant l'objet de la revendication 1.

La disposition proposée met à profit le fait que les feuilles de verre, notamment si leur épaisseur n'est pas très importante, peuvent subir des déformations élastiques sans entraîner de rupture tant que les contraintes engendrées par ces déformations restent bien dans certaines limites. En associant une feuille mince plane à au moins une feuille plus épaisse incurvée, on impose à l'ensemble une incurvation qui ne nécessite pas un traitement thermique de la feuille mince, en dehors de celui lié à l'assemblage en étuve. Ce dernier traditionnellement qui permet d'obtenir une fixation permanente des feuilles au moyen d'un matériau thermoplastique du type polyvinyl-butyral (PVB) ou ethylène-vinyl-acétate (EVA) ne requiert pas de températures supérieures à 120°C, températures qui ne conduisent pas à la dégradation du matériau photovoltaïque.

La déformation mécanique de la feuille de support du dispositif photovoltaïque n'est possible que dans certaines limites d'épaisseur de cette feuille. Plus la feuille est épaisse plus réduite est la déformation dans les limites des contraintes induites supportables. En pratique l'épaisseur de cette feuille mince n'est pas supérieure à 1mm. De façon préférée l'épaisseur n'est pas supérieure à 0,6mm et de façon particulièrement préféré pas supérieure à 0,4mm.

La maîtrise des épaisseurs permet la production de feuilles de verre de 0,1mm et même moins. La difficulté en dessous d'une certaine épaisseur vient en particulier de l'utilisation de ces feuilles dans les techniques de revêtement mises en œuvre pour constituer les systèmes photovoltaïques. Les feuilles très peu épaisses ont tendance à se déformer sous leur propre poids. Pour les maintenir parfaitement planes dans ces opérations de revêtement, il est nécessaire de les disposer sur un support temporaire suffisamment rigide, ce qui complique sensiblement les techniques de production.

Si la feuille plane doit être relativement mince, à l'inverse la ou les feuilles préalablement incurvées associées doivent être suffisamment rigide pour imposer à l'ensemble feuilleté l'incurvation qui est pratiquement celle de cette ou ces feuilles plus épaisses. A titre indicatif, l'épaisseur de la feuille mince plane n'est pas de préférence supérieure au tiers de l'épaisseur de la feuille ou de l'épaisseur totale des feuilles préalablement incurvées.

Les vitrages entrant dans la constitution des toits doivent aussi respecter des règles en terme notamment de tenue mécanique et leur poids ne doit pas constituer un obstacle significatif surtout pour des véhicules devant minimiser la consommation énergétique. Ces diverses contraintes ont pour conséquence de limiter les épaisseurs des feuilles incurvées. Pour une feuille incurvée unique l'épaisseur ne dépasse pas avantageusement 3,2mm et de préférence pas 2,1mm.

Lorsque deux feuilles incurvées sont présentes dans l'assemblage, la feuille mince plane est disposée entre ces deux feuilles. L'épaisseur totale des deux feuilles incurvée n'est pas supérieure à 4,8mm et de préférence pas supérieure à 4,2mm. Les deux feuilles ont des épaisseurs qui ne sont pas nécessairement identiques. De préférence aucune des feuilles incurvées ne présente une épaisseur supérieure à 2,6mm, et avantageusement pas supérieure à 2,1mm.

En dehors de l'épaisseur des feuilles de verre, les courbures imposées pour ces toits ne doivent pas être excessives, au moins dans les parties incorporant la feuille mince plane. En pratique dans ces parties le rayon de courbure imposé n'est pas inférieur à 2m, et de préférence pas inférieure à 4m, pour maintenir les contraintes dans des limites qui ne compromettent pas la fiabilité de ces structures. Pour de toits dont le dessin nécessiterait des courbures sensiblement plus accentuées notamment sur les bords pour accoster la carrosserie, Il est préférable de ne disposer la feuille portant les systèmes photovoltaïques que dans les parties dont les courbures restent dans la limite indiquée. Un mode de réalisation de ce vitrage fait l'objet d'un exemple dans la suite de la description.

Les feuilles de verre minces supportant les systèmes photovoltaïques du fait des déformations qui leur sont imposées doivent pouvoir résister à des contraintes mécaniques permanentes. La limite des contraintes qui peuvent être imposées en gardant une marge de sécurité importante, dépend aussi des caractéristiques mécaniques de la feuille. Il est bien connu, pour améliorer la résistance, de procéder à une trempe de la feuille. Les limites de rupture sont largement repoussées en imposant des différences de contraintes entre les parties superficielles et le cœur de la feuille.

Deux modes de trempe sont traditionnellement utilisés, la trempe thermique et la trempe chimique. Dans le cas des feuilles minces utilisées la trempe thermique présente de nombreuses difficultés. De plus le passage à l'étuve au cours de l'assemblage est susceptible de réduire l'état des contraintes. Aussi selon l'invention il est préféré de procéder à une trempe chimique de cette feuille mince. La trempe chimique est pratiquement insensible aux traitements imposés ultérieurement à cette feuille notamment au cours de l'assemblage final.

Dans les feuilles non trempées, les contraintes qui peuvent être imposées par la déformation mécanique en extension ne doivent pas de préférence dépasser 10MPa. Dans les feuilles trempées ces contraintes peuvent s'élever sans risque excessif jusqu'à 50MPa.

Les systèmes photovoltaïques selon l'invention sont avantageusement à base de semi-conducteur de silicium. Dans ces systèmes le silicium peut se trouver sous forme amorphe ou sous forme cristalline en fonction du mode de production des couches. Le spectre d'absorption du rayonnement n'est pas identique pour ces deux types de structure. L'absorption est plus dans le bleu pour la structure amorphe et plus vers le rouge pour les structures microcristallines.

Selon l'invention, pour obtenir le meilleur rendement de conversion il est avantageux de combiner les deux types en superposant silicium amorphe et le silicium microcristallin.

Le vitrage formant le toit du véhicule comporte vers l'extérieur une feuille qui est aussi transparente que possible pour optimiser le rendement énergétique. Dans ce sens il est avantageux que cette feuille soit de verre clair avec une transmission lumineuse qui n'est pas inférieure à 90% pour une épaisseur de 3mm. Il est aussi possible d'utiliser du verre « extra-clair », mais le gain en termes de transmission et donc d'énergie est limité, la TL passant à au moins 92% toujours pour 3mm d'épaisseur. Bien entendu il est possible d'utiliser des verres colorés, mais au détriment des performances des systèmes photovoltaïques.

L'épaisseur de la feuille de verre externe est l'objet d'un compromis nécessaire entre la résistance mécanique requise par les constructeurs et la transmission dont il est question ci-dessus. Une feuille trop mince peut être insuffisamment résistante aux aléas d'impact de gravillons. Même si le toit n'est pas le plus exposé à cet aléa, les constructeurs ne veulent pas que cette feuille soit trop mince. Pour cette raison comme il est indiqué dans les exemples ultérieurs, la feuille plane mince n'est pas disposée vers l'extérieur dans l'assemblage feuilleté bien que cette disposition soit plus favorable en termes de rendement énergétique.

L'invention est décrite en détail dans la suite en faisant référence aux dessins dans lesquels :
- la figure 1 présente de façon schématique des éléments entrant dans la composition d'un toit selon l'invention ;
- la figure 2 est le toit obtenu après assemblage des éléments de la figure 1 ;
- la figure 3 présente de façon analogue un toit selon l'invention d'une autre composition ;
- la figure 4 est un toit selon l'invention également d'une autre composition
- la figure 5 présente en perspective une partie d'un système photovoltaïque et de son support verrier tel que présenté aux figures 3 ou 4 ;
- la figure 6 est une vue analogue à la précédente avec une disposition améliorant la transmission lumineuse du toit ;
- la figure 7 présente en coupe un détail de la disposition de la figure 6 ;
- la figure 8 est un graphique présentant les spectres d'absorption des couches de silice amorphe (A), et microcristalline (M), avec en regard le spectre solaire (SS).

La composition de base d'un toit selon l'invention comprend au moins deux feuilles de verre 1, 2. La feuille la plus épaisse 1 est préalablement incurvée dans une opération antérieure traditionnelle. La courbe représentée est très accentuée par rapport aux formes effectives mises en œuvre dans le seul but de faire ressortir les particularités de l'invention. La feuille 2 sensiblement moins épaisse est plane ou sensiblement plane. Elle porte, ce qui n'est pas représenté sur la figure, un ensemble photovoltaïque sur la face qui est tournée vers la feuille 1. Une feuille intercalaire thermoplastique 3 de type PVB complète l'ensemble et permet d'en assurer la cohésion dans le toit fini.

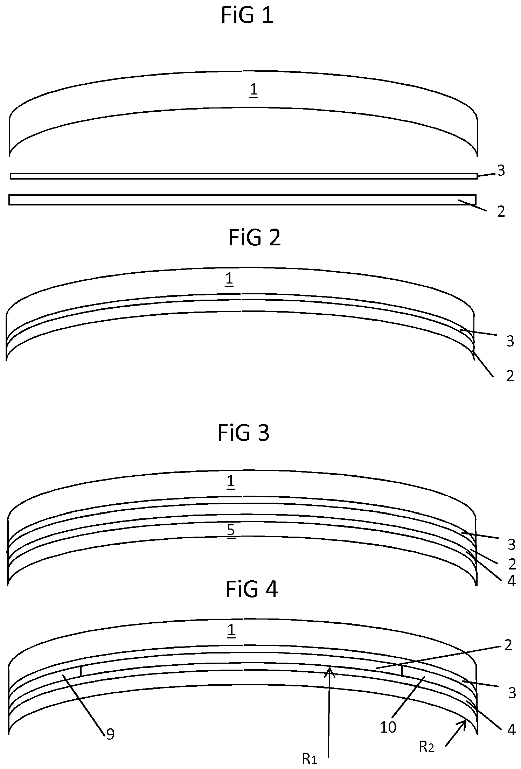

L'assemblage des feuilles est effectué par exemple dans des sacs dans lesquels on impose par le vide la déformation de la feuille mince 2 qui vient s'appliquer sur la feuille incurvée 1 avec la feuille intercalaire 3 comme intermédiaire. Le passage de l'ensemble à l'étuve fait adhérer les feuilles les unes aux autres de manière que la feuille de verre 2 conserve la forme imposée par la feuille 1, comme représenté à la figure 2 de façon schématique.

Comme indiqué précédemment la feuille la plus épaisse est disposée pour être exposée à l'extérieur. Cette structure garantit une meilleure résistance aux impacts éventuels, notamment de gravillons. La transmission lumineuse étant fonction de l'épaisseur de la feuille il s'agit d'un compromis entre cette résistance mécanique et l'optimisation de l'énergie produite. Evidemment il est préférable de choisir la feuille de verre externe 1 de sorte que sa transmission dans le domaine utile au système photovoltaïque soit la plus élevée possible. Dans ce sens un verre clair est préférable à un verre coloré. Pour la feuille de verre mince 2 aucune restriction ne découle de sa fonction si ce n'est comme on le verra plus loin dans la limite que l'on choisit dans l'établissement d'une certaine transmission lumineuse par le toit.

Dans la représentation des figures 1 et 2 les systèmes photovoltaïques sont disposés sur la face convexe de la feuille 2 qui subit la déformation. Dans cette position les couches sont soumises à une extension. Compte tenu des limites imposées aux déformations de la feuille de verre qui les supporte, ces déformations ne présentent pas de risque en ce qui concerne la continuité des couches. De même les tensions à 1"intérieur de l'assemblage feuilleté restent suffisamment faibles pour qu'aucun risque de délamination n'apparaisse.

Si néanmoins il est préféré de faire en sorte que les systèmes photovoltaïques soient déformés en compression, il est possible de choisir une structure du type de celles présentées aux figures 3 et 4. Le système photovoltaïque étant dans la concavité de la feuille 2, dans l'hypothèse de l'utilisation de deux feuilles de verre, le système serait directement exposé vers l'habitacle. Il est donc nécessaire de prévoir une protection supplémentaire.

Dans ces exemples des figures 3 et 4, la structure comporte une troisième feuille de verre 5 qui vient recouvrir l'ensemble du côté de l'habitacle. Autrement dit la feuille plane 2 portant le système photovoltaïque se trouve prise entre deux feuilles 1 et 5. Dans cet ensemble les deux feuilles 1 et 5 sont préalablement incurvées de façon bien complémentaire. Les deux feuilles contribuent à la bonne mise en forme de la feuille 2 en imposant leur courbure.

Les feuilles 1 et 5 peuvent être d'épaisseur identique ou différente. Dans ce dernier cas, il est préférable de disposer la feuille la plus épaisse faisant face à l'extérieur.

Pour former cet ensemble comprenant 3 feuilles de verre, une deuxième feuille intercalaire de matériau thermoplastique 4 est interposée entre la feuille plane 2 portant le système photovoltaïque et la feuille 5 tournée vers l'habitacle.

Les représentations des figures 1 à 4 montrent des vitrages en coupe dans une partie médiane de ceux-ci. Pour l'illustration les courbures sont exagérées. Elles montrent cependant une tendance effective selon laquelle les courbures ne sont pas uniformes sur toute la largeur. Au centre la courbure est modérée correspondant à un rayon R1. Souvent la courbure s'accentue pour accoster la carrosserie sur les deux côtés suivant un deuxième rayon R2 très inférieur à R1.

Dans le cas de courbures latérales conduisant à des contraintes excessives imposées à la feuille plane, il est possible de limiter l'étendue de la feuille 2 à la partie centrale de grand rayon de courbure. Cette structure est celle représentée à la figure 4. Dans cette disposition l'assemblage est complété par la présence d'intercalaires supplémentaires 9 et 10 encadrant la feuille 2 portant le système photovoltaïque. Il peut s'agir soit de bandes de matériau soit d'une feuille entière entourant la feuille 2 après qu'un logement ait été découpé aux dimensions exactes de la feuille 2. Pour les besoins de l'assemblage, les intercalaires ajoutés 9, 10 sont choisis de préférence d'épaisseur égale à celle de la feuille 2.

Pour que le toit composé d'un vitrage du type représenté à la figure 4 conserve une fonctionnalité significative, la surface de la feuille plane est d'au moins 50% de la surface des feuilles de verre incurvées et de préférence d'au moins 65% de cette surface. Dans cette structure les propriétés optiques sont très sensiblement différentes dans les parties comportant les systèmes photovoltaïques et celles qui n'en comportent pas. L'utilisation d'une feuille 5 très fortement colorée peut en partie masquer les différences de transmission. Néanmoins les différences sont telles qu'il peut être préféré de disposer un revêtement opaque sur les parties ne correspondant pas à la présence du système photovoltaïque. Le revêtement est par exemple d'émail sombre. Il peut être appliqué sur l'une des feuilles 1 ou 5.

Les figures 1 à 4 présentent des coupes transversales. Les vitrages des toits offrent ordinairement des courbures dans le sens longitudinal. Dans ce cas c'est la combinaison de ces courbures qui détermine le niveau des contraintes dans la feuille de verre 2. En pratique au moins l'une des courbures dans une des directions, transversale et longitudinale est très peu marquée de telle sorte que les contraintes imposées restent dans les limites indiquées précédemment.

Les figures précédentes ne montrent pas le détail des systèmes photovoltaïques. La très faible épaisseur de ces systèmes, au plus quelques microns, intervient peu dans la structure générale de ces vitrages. Pour illustrer la composition de ces systèmes, aux figures suivantes leurs épaisseurs sont volontairement disproportionnées Par mesure de simplicité, ces figures représentent des fragments des ensembles photovoltaïques sans faire apparaître les courbures qui leur sont imposées dans les vitrages selon l'invention.

Les dispositions de ces systèmes correspondent à celles des figures 3 et 4. Mais dans la composition les mêmes éléments s'appliquent aux toits ne comportant que deux feuilles de verre.

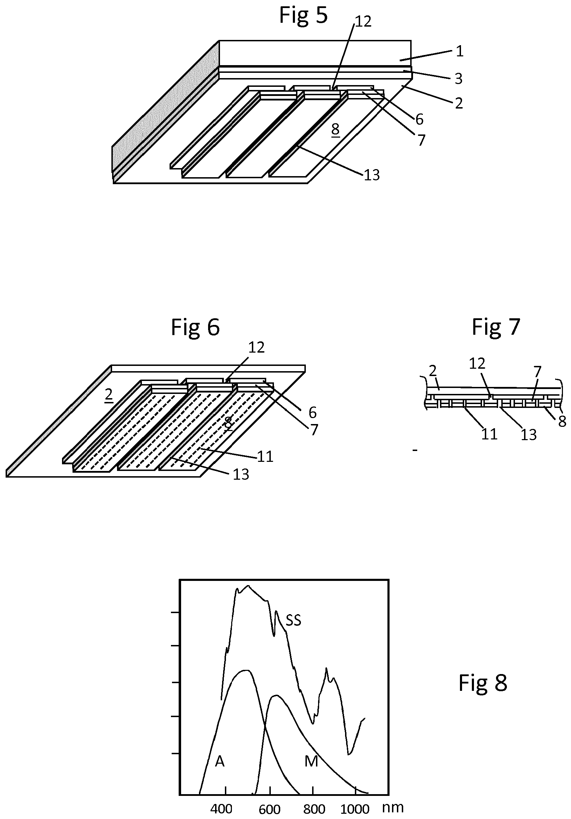

Le fragment de la figure 5 montre la feuille épaisse incurvée 1, l'intercalaire thermoplastique 2 qui assure l'assemblage avec la feuille de verre plane 2 portant les éléments du système photovoltaïque. Celui-ci comprend d'une part la couche semi-conductrice 7, par exemple à base de silicium, et deux électrodes de part et d'autre 6 et 8.

L'électrode 6 est essentiellement transparente. Elle est avantageusement formée d'une couche d'oxyde mince conducteur (TCO). Ces couches bien connues dans le domaine sont ordinairement appliquées directement sur la feuille de verre, et le plus souvent au moment de la production de cette feuille à la sortie des « floats ». L'application est avantageusement réalisée par pyrolyse gazeuse (CVD). Mais d'autres techniques sont également adéquates, notamment les techniques de pulvérisation cathodique sous vide. Des couches de ce type sont par exemple des couches d'oxyde d'étain dopé au fluor, ou d'oxyde d'indium et d'étain (ITO).

Les couches TCO présentent des épaisseurs de quelques nanomètres ou dizaines de nanomètres et sont très faiblement absorbantes. Elles recouvrent de façon uniforme la surface de la feuille de verre 2, mais peuvent également présenter une découpe selon un motif déterminé pour constituer un circuit conducteur compartimenté. Le motif est par exemple constitué par ablation à partir de la couche uniforme, suivant des traits représentés en 12.

Le matériau semi-conducteur 7 est appliqué directement sur la couche conductrice. La couche 7 est beaucoup moins conductrice que la couche TCO de sorte que si cette couche 7 remplit les lignes 12 découpées dans la couche 6 et vient au contact de la feuille 2, les éléments de cellules néanmoins paraissent comme distincts selon la découpe des lignes 12. Aux figures 5 et 6 la représentation schématique ne présente pas la couche 7 au contact de la feuille 2 par mesure de simplicité de lecture de ces figures. Ce n'est pas le cas de la représentation faite de ces couches à la figure 7.

Les modes de production des couches semi-conductrices sont analogues aux précédents, CVD, pulvérisation cathodique...Comme indiqué précédemment, dans l'utilisation de semi-conducteur à base de silicium il est avantageux de combiner plusieurs natures cristallographiques pour optimiser la conversion photovoltaïque. L'absorption lumineuse de ces deux structures étant suffisamment différenciée.

Le graphique de la figure 8 illustre les deux types d'absorption et leur complémentarité. La superposition de deux couches l'une de silicium amorphe, l'autre de silicium microcristallin améliore le rendement du système de façon sensible, tout en conservant des épaisseurs relativement minces de l'ordre de quelques micromètres. Les couches semi-conductrices, même relativement minces, font pratiquement obstacle à la transmission de la lumière. Cette transmission est dans tous les cas écartée par l'utilisation d'une deuxième électrode représentée en 8, qui doit avantageusement ajouter à son caractère conducteur la capacité à réfléchir le rayonnement non absorbé au franchissement de la couche semi-conductrice 7, imposant un second passage dans celle-ci pour améliorer le rendement. Des électrodes de ce type sont éventuellement des couches d'oxyde conducteur suffisamment réfléchissant, par exemple des couches à base de ZnO dopé à l'aluminium au gallium ou au bore. Il peut aussi s'agir de systèmes comprenant en outre une couche formant miroir.

La couche semi-conductrice (ou les couches), est éventuellement composée d'éléments juxtaposés pour former un ensemble capable de fournir la tension souhaitée comme illustré aux figures 5, 6 et 7.

Par ailleurs, selon l'invention, il est nécessaire de conserver une certaine transmission lumineuse. De préférence cette transmission lumineuse est maintenue entre 5 et 30% de la lumière incidente et avantageusement de 8 à 20%. Les couches semi-conductrices de même que les électrodes 8 étant essentiellement opaques, il est nécessaire de rompre leur continuité.

Les figures 5 et 6 montrent des éléments photovoltaïques individualisés par des lignes 13 qui rompent les couches 7 et 8. Ces lignes sont tracées soit directement lors de la formation des couches par des éléments de masquage, soit sur des couches uniformes par ablation localisée, par exemple par des techniques mettant en œuvre des lasers.

La présence des lignes 13 réduit nécessairement la surface utile pour les éléments photovoltaïque aussi, ces lignes comme indiqué précédemment ne doivent pas représenter une proportion de la surface trop importante.

La présence de lignes fines 12 peut être insuffisante pour obtenir le niveau de transmission demandé. La présence de lignes plus larges pourrait conduire à des contrastes trop accentués, rendant perceptible l'absence d'uniformité dans la transmission sur la surface considérée. Pour accroître la surface présentant une bonne transmission lumineuse, tout en distribuant de façon plus uniforme les parties apparaissant comme sources lumineuses, il est possible de ménager des ouvertures 11 dans les couches des systèmes photovoltaïques. De telles ouvertures peuvent également être obtenues comme les lignes, notamment par ablation laser.

La figure 7 montre en coupe une distribution de lignes 12 et 13, et d'ouvertures 11 dans les couches 6, et 7 et 8.

Pour donner une impression de transmission bien distribuée sur la surface, les lignes et les ouvertures sont elles-mêmes réparties aussi uniformément que possible sur cette surface.

## Revendications

1. Procédé de fabrication d'un vitrage de véhicule, formant un toit, comprenant un ensemble de feuilles (1, 5) de verre incurvé, assemblées en un feuilleté au moyen d'intercalaires (3, 4) thermoplastiques, une partie au moins de cet ensemble comportant un dispositif photovoltaïque (2) constitué d'une ou plusieurs couches semi-conductrices et de part et d'autre de couches conductrices minces formant électrodes, toit dans lequel au moins la partie du dispositif photovoltaïque comprenant la ou les couches semi-conductrices, est constituée sur une feuille de verre sensiblement plane (2) dont l'épaisseur n'est pas supérieur à 1mm laquelle, dans l'assemblage feuilleté, est associée à au moins une feuille de verre plus épaisse préalablement incurvée.

2. Procédé de fabrication d'un vitrage selon la revendication 1 dans lequel le matériau des couches semi-conductrices de l'ensemble photovoltaïque est à base de silicium.

3. Procédé de fabrication d'un vitrage selon l'une des revendications précédentes dans lequel la feuille plane sur laquelle est constituée la ou les couches semi-conductrices, présente une épaisseur qui n'est pas supérieure à 1mm, de façon préférée pas supérieure à 0,6mm et de façon particulièrement préférée pas supérieure à o,4mm.

4. Procédé de fabrication d'un vitrage selon l'une des revendications précédentes dans lequel l'épaisseur de la feuille plane n'est pas supérieure au tiers de l'épaisseur de la feuille incurvée, ou de la somme des épaisseurs des feuilles incurvées.

5. Procédé de fabrication d'un vitrage selon l'une des revendications précédentes dans lequel une seule feuille incurvée est présente, l'épaisseur de celle-ci ne dépassant pas 3,2mm et de préférence pas 2,1mm.

6. Procédé de fabrication d'un vitrage selon l'une des revendications 1 à 4 entrant dans la composition d'un toit de véhicule, dans lequel deux feuilles incurvées sont utilisées dans l'assemblage, l'épaisseur totale de ces deux feuilles n'étant pas supérieure à 4,8mm et de préférence pas supérieure à 4,2mm.

7. Procédé de fabrication d'un vitrage selon la revendication 6 dans lequel aucune des feuilles incurvées ne présente une épaisseur supérieure à 2,6mm et de préférence pas supérieure à 2,1mm.

8. Procédé de fabrication d'un vitrage selon l'une des revendications précédentes dans lequel le rayon de courbure le plus petit imposé à la feuille plane dans l'association avec une ou plusieurs feuilles préalablement incurvées n'est pas inférieur à 2m.

9. Procédé de fabrication d'un vitrage selon l'une des revendications précédentes dans lequel la feuille plane portant le dispositif photovoltaïque est une feuille de verre trempée chimiquement.

10. Procédé de fabrication d'un vitrage selon l'une des revendications précédentes dans lequel les courbures imposées à la feuille de verre plane n'induisent pas de contraintes en extension supérieures à 10MPa pour les feuilles non-trempées et pas supérieures à 50MPa pour les feuilles trempées.

11. Procédé de fabrication d'un vitrage selon l'une des revendications 6 à 10 dans lequel partant de l'extérieur la structure comprend une première feuille de verre préalablement incurvée, une feuille intercalaire thermoplastique, une feuille de verre portant les couches du dispositif photovoltaïque, une deuxième feuille intercalaire thermoplastique, une deuxième feuille de verre préalablement incurvée.

12. Procédé de fabrication d'un vitrage selon la revendication 11 dans lequel la feuille de verre portant les couches du dispositif photovoltaïque ne s'étend que sur une partie de la surface du toit, partie qui n'est pas inférieure à 50% de la surface totale.

13. Procédé de fabrication d'un vitrage selon la revendication 12 dans lequel la feuille de verre portant les couches du dispositif photovoltaïque est disposée dans la partie présentant les courbures les plus faibles.

14. Procédé de fabrication d'un vitrage selon l'une des revendications précédentes dans lequel les couches conductrices formant électrodes comprennent au moins une couche d'oxyde mince (TCO) essentiellement transparente au rayonnement visible, cette couche étant disposée dans le sens d'irradiation au-dessus de la, ou des couches semi-conductrices.

15. Procédé de fabrication d'un vitrage selon l'une des revendications précédentes dans lequel la couche conductrice située sur la face de la ou des couches semi-conductrices, du côté opposée au sens d'irradiation, comporte une couche d'oxyde conducteur et une couche métallique réfléchissant au moins partiellement le rayonnement non absorbé au passage de la couche semi-conductrice.

16. Procédé de fabrication d'un vitrage selon l'une des revendications précédentes dans lequel le dispositif photovoltaïque comprend un ensemble de deux couches, l'une constituée de silicium amorphe, l'autre de silicium microcristallin.

17. Procédé de fabrication d'un vitrage selon l'une des revendications précédentes dans lequel la transmission lumineuse est maintenue entre 5 et 30%, de préférence entre 8 et 20% dans la partie comportant le dispositif photovoltaïque, par des interruptions de ce dispositif présentant la forme de lignes et/ou de défauts ponctuels de revêtement de la feuille qui supporte ce dispositif.

18. Procédé de fabrication d'un vitrage selon la revendication 17 dans lequel les interruptions sont faites par ablation au moyen de laser, et/ou par masquage au moment de la constitution de ces couches.

## Patentansprüche

1. Verfahren zur Herstellung einer ein Dach bildenden Fahrzeugverglasung, umfassend eine Anordnung aus Scheiben (1, 5) aus gebogenem Glas, die mittels von thermoplastischen Zwischenlagen (3, 4) zu einem Verbundsicherheitsglas verbunden sind, wobei mindestens ein Teil dieser Anordnung eine Photovoltaik-Vorrichtung (2) beinhaltet, die aus einer oder mehreren halbleitenden Schichten und auf beiden Seiten aus dünnen leitenden Schichten, die Elektroden bilden, aufgebaut ist, wobei in dem Dach mindestens der Teil der Photovoltaik-Vorrichtung, der die halbleitende(n) Schicht(en) umfasst, auf einer im Wesentlichen flachen Glasscheibe (2) aufgebaut ist, deren Dicke nicht mehr als 1 mm beträgt und die, in dem Verbundsicherheitsglasverband, mindestens einer zuvor gebogenen dickeren Glasscheibe zugeordnet ist.

2. Verfahren zur Herstellung einer Verglasung nach Anspruch 1, bei dem das Material der halbleitenden Schichten der Photovoltaik-Anordnung auf der Basis von Silicium ist.

3. Verfahren zur Herstellung einer Verglasung nach einem der vorhergehenden Ansprüche, bei dem die flache Scheibe, auf der die halbleitende(n) Schichten(en) aufgebaut ist(sind), eine Dicke aufweist, die nicht mehr als 1 mm, bevorzugt nicht mehr als 0,6 mm und besonders bevorzugt nicht mehr als 0,4 mm beträgt.

4. Verfahren zur Herstellung einer Verglasung nach einem der vorhergehenden Ansprüche, bei dem die Dicke der flachen Scheibe nicht mehr als ein Drittel der Dicke der gebogenen Scheibe oder der Summe der Dicken der gebogenen Scheiben beträgt.

5. Verfahren zur Herstellung einer Verglasung nach einem der vorhergehenden Ansprüche, bei dem eine einzige gebogene Scheibe vorhanden ist, wobei deren Dicke 3,2 mm und bevorzugt 2,1 mm nicht übersteigt.

6. Verfahren zur Herstellung einer Verglasung nach einem der Ansprüche 1 bis 4, die in den Aufbau eines Fahrzeugdachs eingeht, bei dem in dem Verbund zwei gebogene Scheiben verwendet werden, wobei die Gesamtdicke dieser beiden Scheiben nicht mehr als 4,8 mm, bevorzugt nicht mehr als 4,2 mm beträgt.

7. Verfahren zur Herstellung einer Verglasung nach Anspruch 6, bei dem keine der gebogenen Scheiben eine Dicke von mehr als 2,6 mm und bevorzugt von mehr als 2,1 mm aufweist.

8. Verfahren zur Herstellung einer Verglasung nach einem der vorhergehenden Ansprüche, bei dem der kleinste Krümmungsradius, welcher der flachen Scheibe in dem Verbund mit einer oder mehreren zuvor gebogenen Scheiben aufgeprägt wird, nicht weniger als 2 m beträgt.

9. Verfahren zur Herstellung einer Verglasung nach einem der vorhergehenden Ansprüche, bei dem die flache Scheibe, welche die Photovoltaik-Vorrichtung trägt, eine Scheibe aus chemisch vorgespanntem Glas ist.

10. Verfahren zur Herstellung einer Verglasung nach einem der vorhergehenden Ansprüche, bei dem die Krümmungen, die der flachen Glasscheibe aufgeprägt werden, zu keinen Dehnbeanspruchungen von mehr als 10 Mpa bei nicht vorgespannten Scheiben und von mehr als 50 Mpa bei vorgespannten Scheiben führen.

11. Verfahren zur Herstellung einer Verglasung nach einem der Ansprüche 6 bis 10, bei dem die Struktur ausgehend von der Außenseite eine erste zuvor gebogene Glasscheibe, eine thermoplastische Zwischenlagenfolie, eine die Schichten der Photovoltaik-Vorrichtung tragende Glasscheibe, eine zweite thermoplastische Zwischenlagenfolie, eine zweite zuvor gebogene Glasscheibe umfasst.

12. Verfahren zur Herstellung einer Verglasung nach Anspruch 11, bei dem sich die Glasscheibe, welche die Schichten der Photovoltaik-Vorrichtung trägt, nur über einen Teil der Fläche des Dachs erstreckt, der nicht weniger als 50 % der Gesamtfläche beträgt.

13. Verfahren zur Herstellung einer Verglasung nach Anspruch 12, bei dem die Glasscheibe, welche die Schichten der Photovoltaik-Vorrichtung trägt, in dem Teil angeordnet ist, der die geringsten Krümmungen aufweist.

14. Verfahren zur Herstellung einer Verglasung nach einem der vorhergehenden Ansprüche, bei dem die leitenden Schichten, die Elektroden bilden, mindestens eine für sichtbare Strahlung im Wesentlichen transparente dünne Oxidschicht (TCO) umfassen, wobei diese Schicht in Einstrahlungsrichtung über der oder den halbleitenden Schicht(en) angeordnet ist.

15. Verfahren zur Herstellung einer Verglasung nach einem der vorhergehenden Ansprüche, bei dem die leitende Schicht, die auf der Seite der halbleitende(n) Schichten (en) gelegen ist, auf der zur Einstrahlungsrichtung entgegengesetzten Seite eine Schicht aus leitendem Oxid und eine Metallschicht, welche die beim Passieren der halbleitenden Schicht nicht absorbierte Strahlung mindestens teilweise reflektiert, beinhaltet.

16. Verfahren zur Herstellung einer Verglasung nach einem der vorhergehenden Ansprüche, bei dem die Photovoltaik-Vorrichtung eine Anordnung aus zwei Schichten umfasst, von denen die eine aus amorphem Silicium, die andere aus mikrokristallinem Silicium aufgebaut ist.

17. Verfahren zur Herstellung einer Verglasung nach einem der vorhergehenden Ansprüche, bei dem die Lichttransmission zwischen 5 und 30 %, bevorzugt zwischen 8 und 20 % in dem Teil, der die Photovoltaik-Vorrichtung beinhaltet, aufrechterhalten wird durch Unterbrechungen dieser Vorrichtung, welche die Form von Linien und/oder punktuellen Fehlstellen der Beschichtung der Scheibe, die diese Vorrichtung stützt, aufweisen.

18. Verfahren zur Herstellung einer Verglasung nach Anspruch 17, bei dem die Unterbrechungen durch Ablation mittels Laer und/oder durch Maskieren zum Zeitpunkt des Aufbaus dieser Schichten ausgeführt werden.

## Claims

1. Process for manufacturing an automotive glazing unit, forming a roof, comprising a curved stack of glass sheets (1, 5) assembled into a laminate by means of thermoplastic interlayers (3, 4), at least one portion of this stack comprising a photovoltaic device (2) formed from one or more semiconductor layers and, on either side, of thin conductive layers forming electrodes, in which roof at least the portion of the photovoltaic device comprising the one or more semiconductor layers is formed on a substantially planar glass sheet (2) the thickness of which is no larger than 1 mm and which, in the laminated assembly, is associated with at least one thicker curved glass sheet bent beforehand.

2. Process for manufacturing a glazing unit as claimed in claim 1, in which the material of the semiconductor layers of the photovoltaic stack is based on silicon.

3. Process for manufacturing a glazing unit as claimed in one of the preceding claims, in which the planar sheet on which the one or more semiconductor layers are formed has a thickness that is no larger than 1 mm, preferably no larger than 0.6 mm and particularly preferably no larger than 0.4 mm.

4. Process for manufacturing a glazing unit as claimed in the preceding claims, in which the thickness of the planar sheet is no larger than one third of the thickness of the curved sheet, or of the sum of the thicknesses of the curved sheets.

5. Process for manufacturing a glazing unit as claimed in one of the preceding claims, in which a single curved sheet is present, the thickness of the latter not exceeding 3.2 mm and preferably not exceeding 2.1 mm.

6. Process for manufacturing a glazing unit as claimed in one of claims 1 to 4, entering into the composition of a vehicle roof, in which two curved sheets are used in the assembly, the total thickness of these two sheets being no larger than 4.8 mm and preferably no larger than 4.2 mm.

7. Process for manufacturing a glazing unit as claimed in claim 6, in which none of the curved sheets has a thickness larger than 2.6 mm and preferably than 2.1 mm.

8. Process for manufacturing a glazing unit as claimed in one of the preceding claims, in which the smallest radius of curvature imposed on the planar sheet in the association with one or more curved sheets bent beforehand is no smaller than 2 m.

9. Process for manufacturing a glazing unit as claimed in one of the preceding claims, in which the planar sheet bearing the photovoltaic device is a chemically tempered glass sheet.

10. Process for manufacturing a glazing unit as claimed in one of the preceding claims, in which the curvatures imposed on the planar glass sheet induce tensile stresses no higher than 10 MPa for untempered sheets and no higher than 50 MPa for tempered sheets.

11. Process for manufacturing a glazing unit as claimed in one of claims 6 to 10, in which, starting from the exterior, the structure comprises a first curved glass sheet bent beforehand, a thermoplastic interlayer, a glass sheet bearing the layers of the photovoltaic device, a second thermoplastic interlayer and a second curved glass sheet bent beforehand.

12. Process for manufacturing a glazing unit as claimed in claim 11, in which the glass sheet bearing the layers of the photovoltaic device extends only over a portion of the area of the roof, which portion is no smaller than 50% of the total area.

13. Process for manufacturing a glazing unit as claimed in claim 12, in which the glass sheet bearing the layers of the photovoltaic device is placed in the portion having the smallest curvatures.

14. Process for manufacturing a glazing unit as claimed in one of the preceding claims, in which the conductive layers forming electrodes comprise at least one thin oxide layer (TCO) that is essentially transparent to visible radiation, this layer being placed in the direction of irradiation above the one or more semiconductor layers.

15. Process for manufacturing a glazing unit as claimed in one of the preceding claims, in which the conductive layer located on the face of the one or more semiconductor layers, on the side opposite the direction of irradiation, comprises a conductive oxide layer and a metal layer that at least partially reflects radiation not absorbed by the semiconductor layer.

16. Process for manufacturing a glazing unit as claimed in one of the preceding claims, in which the photovoltaic device comprises a stack of two layers, one made of amorphous silicon and the other of microcrystalline silicon.

17. Process for manufacturing a glazing unit as claimed in one of the preceding claims, in which the transmittance of light is kept between 5 and 30% and preferably between 8 and 20% in the portion comprising the photovoltaic device, by producing interruptions in this device taking the form of lines and/or of discrete absences in coating from the sheet that supports this device.

18. Process for manufacturing a glazing unit as claimed in claim 17, in which the interruptions are produced by laser ablation and/or by masking when these layers are formed.
